# EUROPEAN PATENT APPLICATION

(11) **EP 0 590 598 A1**
(43) Date of publication of application: **06.04.1994**
(21) Application number: 93115633.5
(22) Date of filing: 28.09.1993
(51) Int. Cl.: H01L 31/0216

(54) **Semiconductor photodiode comprising a light shielding layer**

(30) Priority: 28.09.1992 JP 258378/92; 26.10.1992 JP 287582/92
(71) Applicant: SANYO ELECTRIC CO., LIMITED., Moriguchi City, Osaka (JP)
(72) Inventor: Mita,Keizi,c/o Sanyo Electric Co.Ltd., Moriguchi-City,Osaka (JP)
(74) Representative: Glawe, Delfs, Moll & Partner

(57) **Abstract**

A semiconductor device contains a photodiode and peripheral circuitry formed on a surface of a semiconductor chip and has a light shielding construction. Bonding pads include at least a first and a second layer and are formed around a periphery of the semiconductor chip. An extended part of each bonding pad and a light shield covering a surface of the semiconductor device overlap, thereby shielding the surface of the semiconductor chip from incident light. Electrical isolation between adjacent bonding pads is maintained by interposing an insulating film between the extended part of each bonding pad and the light shield.

## Description

### BACKGROUND OF THE INVENTION

This invention relates to integrated circuits and, more particularly, to integrated circuits which include a means for shielding a photodiode and peripheral circuitry, of an integrated circuit for receiving and processing optical signals, from incident light entering via bonding pad area of the semiconductor device.

Prior art semiconductor devices integrate a photodiode and peripheral circuitry and are used to receive optical signals from infrared rays or from a light pickup device in a reading device. Integration of a photodiode with associated peripheral circuitry reduces manufacturing cost and increases immunity to noise produced by external electromagnetic interference as compared to hybridization of discrete parts,.

In the prior art, a multi-layer wiring technique used to fabricate semiconductor integrated circuits conveniently provides a light-shielding means. Aluminum deposited upon the semiconductor device is used to form bonding pads and an opaque shield layer which prevents light from reaching the peripheral circuitry and inducing erroneous circuit operation due to light striking photo-sensitive p-n junctions in the peripheral circuitry. The opaque shield layer covers the surface of the semiconductor device with the exception of areas required for exposure of the bonding pads and photo-diodes. A clearance area surrounding the bonding pads is required to provide electrical isolation of the bonding pads from the opaque shield layer. The opaque shield layer prevents light from entering a substrate of the semiconductor device through the surface which it covers, however, the clearance areas allow light to enter the substrate and reach the peripheral circuitry either directly or by multi-path reflection. Therefore, a semiconductor device construction for improved light shielding is required.

### OBJECTS AND SUMMARY OF THE INVENTION

Accordingly, it is an object of the present invention to overcome the drawback of the prior art.

It is a still further object of the present invention to provide a semiconductor device, with a built-in photodiode, in which a portion of each bonding pad extends over an insulation film superposed on the light-shielding film.

It is a further object of the present invention to provide a semiconductor device, with a built-in photodiode, in which the bonding pads have a multi-layered structure.

The present invention utilizes multi-layered bonding pads having an extended part electrically isolated from a light-shielding film. Since the extended part of the bonding pad itself functions as a light-shielding film, arranging elements to overlap the periphery of the extended portion of the bonding pad on the light-shielding film covers all possible gaps where light may be incident upon peripheral circuitry. Moreover, an insulation layer between the light-shielding film and the extended portion of the bonding pad maintains electrical isolation between each bonding pad.

Briefly stated, there is provided a semiconductor device containing a photodiode and peripheral circuitry formed on a surface of a semiconductor chip with a light shielding construction. Bonding pads include at least a first and a second layer and are formed around a periphery of the semiconductor chip. An extended part of each bonding pad and a light shield covering a surface of the semiconductor device overlap, thereby shielding the surface of the semiconductor chip from incident light. Electrical isolation between adjacent bonding pads is maintained by interposing an insulating film between the extended part of each bonding pad and the light shield.

According to an embodiment of the present invention, there is provided a semiconductor device, incorporating a photodiode and peripheral circuits in a substrate, comprising: a bonding pad disposed upon the substrate, a light shield covering the peripheral circuits, the bonding pad being electrically insulated from the light shield layer, and the light shield and a first pad layer of the bonding pad overlapping such that direct paths of incident light upon the substrate are occluded.

According to another embodiment of the invention a semiconductor device, incorporating a photodiode and peripheral circuits in a substrate, comprises: first and second bonding pads disposed upon the substrate, a first light shield covering the peripheral circuits and extending up to a clearance area around the first and second bonding pads, a second light shield disposed between the first and second bonding pads, the first and second bonding pads being electrically insulated from the first and second light shields, the first and second bonding pads each having an extended pad layer, and the first light shield, the second light shield, and the extended pad layers of the first and second bonding pads being overlapped such that direct paths of incident light upon the substrate are occluded.

According to a feature of the invention there is provided a semiconductor device, having a photodiode and peripheral circuitry, comprising: a substrate, a plurality of bonding pads, the plurality of bonding pads each including a plurality of pad layers superposed on each other, the plurality of pad layers each including an extended pad layer and a base layer, a first light shield being formed from an uppermost wiring layer deposited on a surface of the semiconductor device and shielding a portion of the substrate from incident light, a second light shield deposited between adjacent bonding pads of the plurality of bonding pads for shielding another portion of the substrate from incident light, the extended pad layer and the second light shield overlapping, thereby shielding still another portion of the substrate between a periphery of the base layer and a periphery of the second light shield, and at least one insulation film disposed between the adjacent bonding pads, the extended pad layer, and the first and second light shields for electrically isolating the adjacent bonding pads from one another and from the first and second light shields.

The above, and other objects, features and advantages of the present invention will become apparent from the following description read in conjunction with the accompanying drawings, in which like reference numerals designate the same elements.

### BRIEF DESCRIPTION OF DRAWINGS

Fig. 1 is an enlarged plan view of a bonding pad portion of a first embodiment of the present invention.

Fig. 2 is a cross-section of the embodiment of Fig. 1 taken along line II-II.

Figs. 3(a)-3(c) are plan views of layers of the embodiment of Fig. 1.

Fig. 4 is a plan view of a second embodiment of the present invention.

Fig. 5 is a cross-section of the embodiment of Fig. 4 taken along line V-V of Fig. 4.

Figs. 6(a)-6(c) are plan views of layers of the embodiment of the present invention.

Fig. 7 is a plan view of a third embodiment of the present invention.

Fig. 8 is a cross-section view of the embodiment of Fig. 7 taken along line VIII-VIII.

Figs. 9(a)-9(c) are plan views of layers of the embodiment of Fig. 7.

Fig. 10 is a plan view illustrating an embodiment of the prior art.

### DETAILED DESCRIPTION OF THE PREFERRED EMBODIMENTS

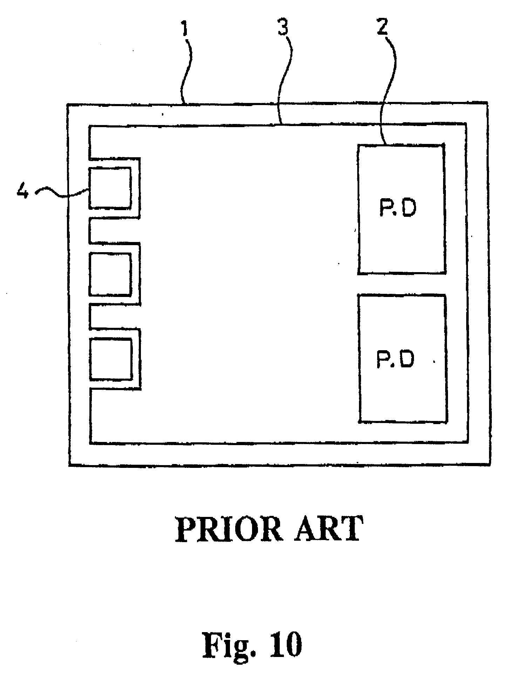

Referring to Fig. 10, a semiconductor chip 1 of the prior art has a light-shielding film functioning as a light shield 3 that covers an entire surface of semiconductor chip 1, excluding photodiodes 2 and bonding pads 4. The light shielding film is formed by aluminum deposited during the forming of a third aluminum wiring layer of the semiconductor chip 1 which also forms a top layer of bonding pads 4 mounted on a periphery of semiconductor chip 1. The surface of each bonding pad 4 must be exposed to permit bonding of a wire thereto. A clearance must exist between bonding pads 4 and light shield 3 to maintain electrical isolation between bonding pads 4 since both are formed of the third aluminum wiring layer of semiconductor chip 1,.

A drawback to the prior art exists in that the resulting clearance between bonding pads 4 and light shield 3 permits incident light to fall therebetween and thus upon the peripheral circuitry of semiconductor chip 1, which includes transistors. The incidence of light upon a PN junction of the transistors induces electric currents therein resulting in erroneous circuit operation.

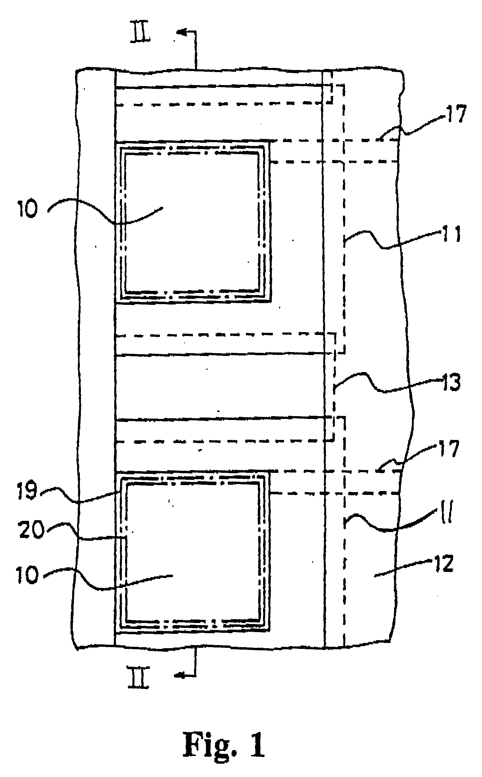

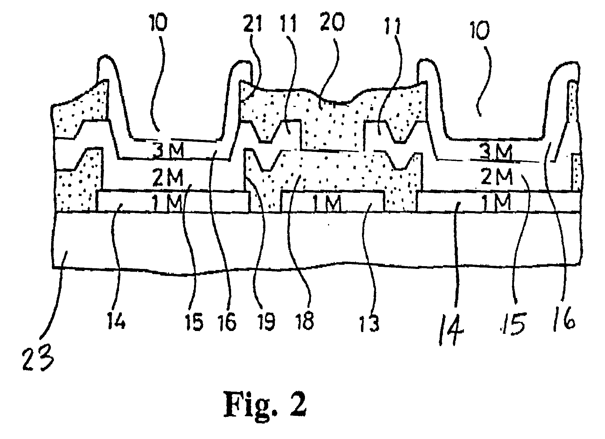

Referring to Figs. 1 and 2, a semiconductor device has bonding pads 10 having a three-layer structure. The semiconductor device contains photodiodes and NPN transistors (not shown) formed in a silicon substrate 23 using standard semiconductor fabrication techniques. The components formed in silicon substrate 23 are electrically connected through a first aluminum wiring layer 1M and a second aluminum wiring layer 2M. A third aluminum wiring layer 3M forms a third bonding pad layer 16 and a light shielding film functioning as a light shield 12 which shields the surface of semiconductor chip 23 from incident light. A passivating layer (not shown) is deposited on third aluminum wiring layer 3M, including light shield 12 and third bonding layer 16, and is then removed from third bonding layer 16 exposing bonding pads 10.

A first layer 14 of bonding pads 10 is formed on a silicon dioxide layer 23 and is a square with each side about 100 to 200 µm in length. A conductor 17 extends from a portion of first layer 14 to connect first layer 14 to internal circuitry (not shown). A second layer 15 of bonding pad 10 is deposited atop first layer 14 via a through-hole 19 in a first layer insulating film 18. Second layer 15 has an extended part 11 extending 50 to 80 µm from the periphery of first layer 14 and over first layer insulation film 18. A dicing line, for separating chips from a wafer, is provided around semiconductor chip 23 and outside of bonding pads 10 such that extended part 11 is not disturbed by a dicing blade. Third bonding pad layer 16 of bonding pads 10 is deposited upon second layer 15 via a through-hole 21, equal in size to through hole 19, in a second layer insulating film 20.

First light shield 12, formed on second layer insulation film 20, covers an entire surface of silicon substrate 23 excluding portions containing photodiodes and portions within 20 to 30 µm of any side of bonding pads 10. First light shield 12 overlaps extended part 11 of bonding pad 10 for about 20 µm. An outer surface of first light shield 12 is covered by the passivating layer as discussed above.

A second light shield 13 is formed on silicon substrate 23 between adjacent bonding pads 10. A lateral side of second light shield 13 is located 20 to 30 µm from the periphery of first layer 14 of neighboring bonding pads 10. Extended part 11 of second layer 15 overlaps second light shield 13 at its lateral side for about 20 µm to cover empty space between the periphery of first layer 14 and the lateral side of second light shield 13. Further, second light shield 13 extends until first light shield 12 overlaps on second light shield 13. Thus, extended part 11 of second layer 15 and second light shield 13 are arranged in a clearance between bonding pads 10 and first light shield 12 to permit complete shielding of silicon substrate 23 without sacrificing the electrical isolation of bonding pad 10.

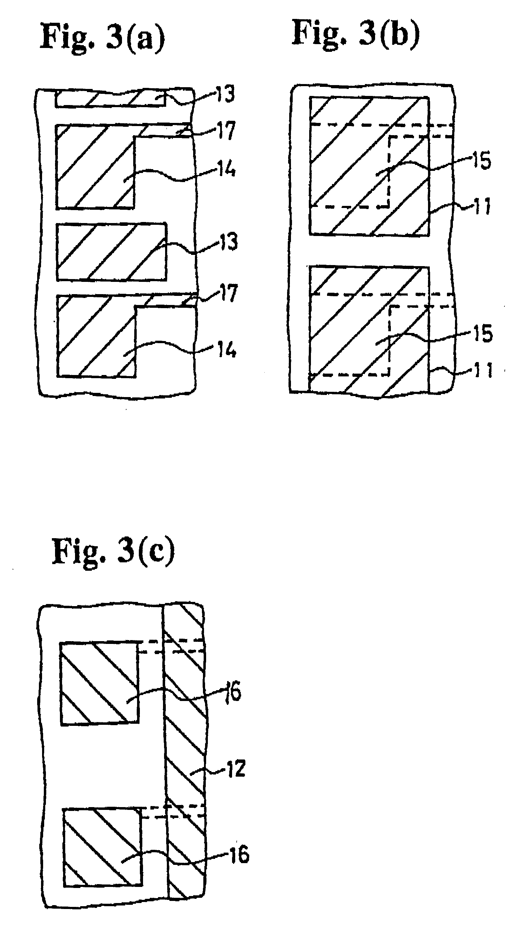

Referring to Fig. 3(a), first layer 14 of bonding pads 10, second light shield 13, and conductor 17 are formed by etching portions of the first aluminum wiring layer. Referring to Fig. 3(b), second layer 15 and extended part 11 of bonding pads 10 are formed by etching portions of the second aluminum wiring layer. Referring to Fig. 3(c), third bonding pad layer 16 of bonding pads 10 and light shield 12 are formed by etching portions of the third aluminum wiring layer. Thus, layers of the bonding pads 10 and first and second light shields, 12 and 13, are configured into an interleaved structure occluding direct incident light paths to a surface of substrate 23.

In the embodiment of Figs. 1 through 3(c) a deficiency exists in that multi-path reflection can occur whereby incident light can reflect from a surface of light shield 13 to the bottom of projecting part 11 and subsequently reach semiconductor chip 23.

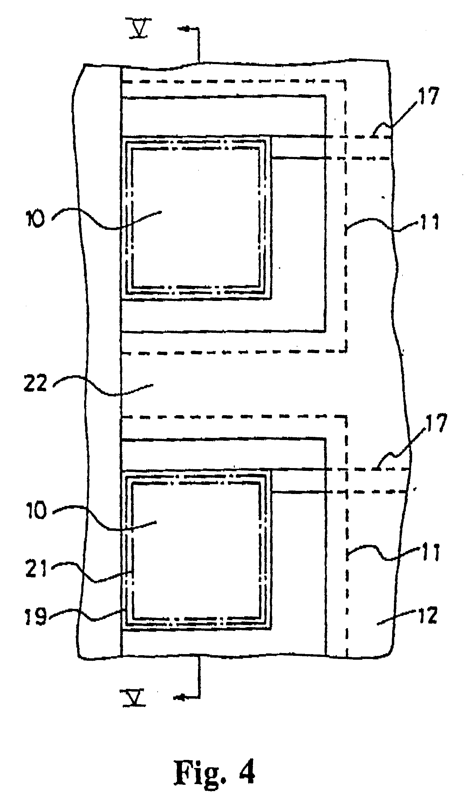

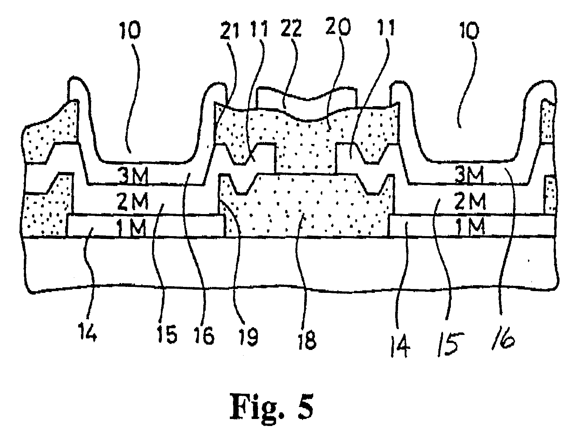

Referring now to Figs. 4 and 5, in a second embodiment of the present invention a projecting part 22 on first light shield 12 extends across and shields the region between adjacent bonding pads 10. Multi-path reflection is reduced since incident light is deflected from the region between adjacent bonding pads 10 before reaching second layer insulation film 20 as occurs in the first embodiment of Figs. 1 through 3(a).

In the second embodiment, projecting part 22 covers an area of second layer insulation film 20 and thus inhibits gasses from escaping from second layer insulation film 20. If second layer insulation film 20 is made from polyamide, for example, first light shield 12 and projecting part 22 must each contain a penetrating hole (not shown) for purging gas. However, each penetrating hole allows incident light to pass through. This passage of light requires that second light shield 13, shown in the first embodiment, be formed on silicon srnbstrate 23 directly below the penetrating holes. Therefore, the second embodiment of Fig. 4 without the second light shield 13 is suitable in applications where a hole for degassing an oxidized film formed by chemical vapor deposition, such as polyamide, is not needed.

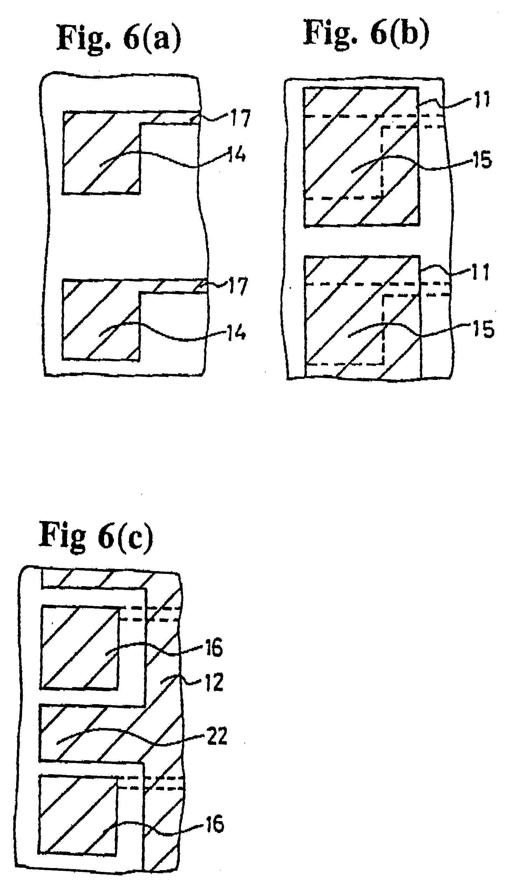

Referring to Fig. 6(a), first layer 14 of bonding pads 10 and conductor 17 are formed by etching portions of the first aluminum wiring layer 1M. Referring to Fig. 6(b), second layer 15 and extended part 11 of bonding pads 10 are formed by etching portions of the second aluminum wiring layer 2M. Referring to Fig. 6(c), third bonding pad layer 16 of bonding pads 10, light shield 12, and projecting part 22 of light shield 12 are formed by etching portions of the third aluminum wiring layer 3M. Thus, layers of the bonding pads 10 and light shields 12 and projecting part 22, are configured into an interleaved structure occluding direct incident light paths to the surface of substrate 23.

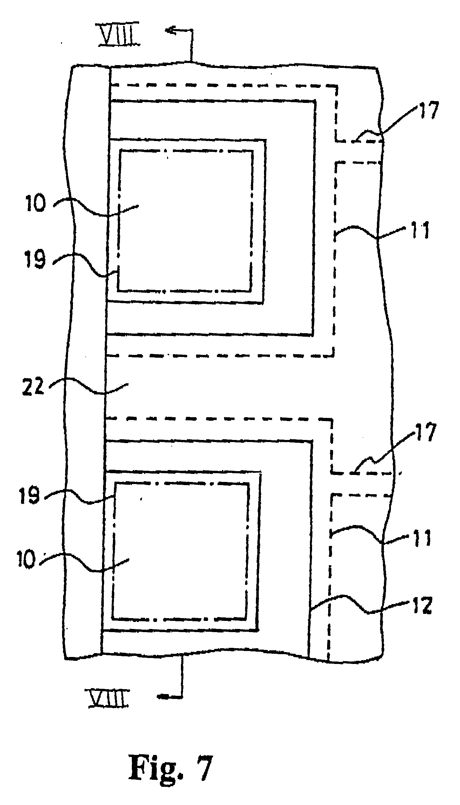

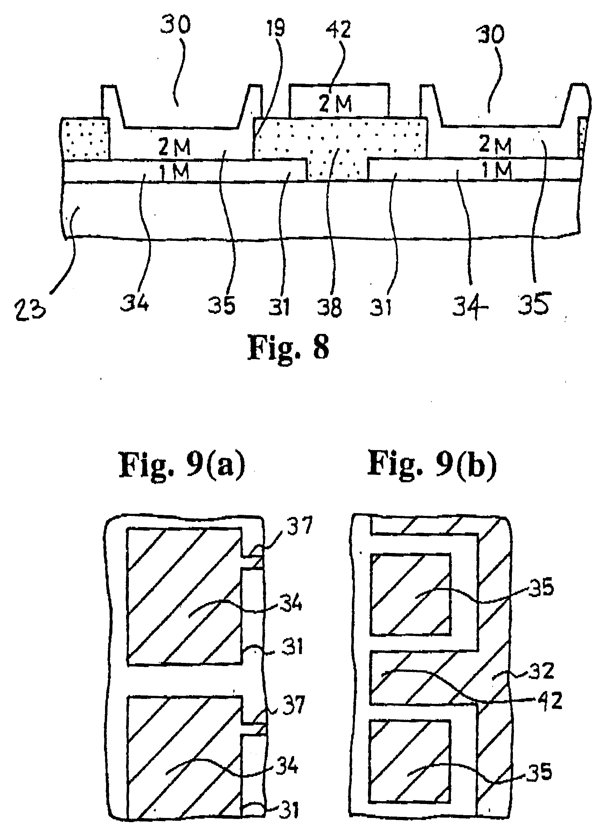

Referring to Figs. 7 and 8, the third embodiment of the present invention has a two-layer structure, as opposed to the three layer structure of the first and second embodiments, and is suitable for use in applications requiring only a single aluminum wiring layer for the interconnection of the peripheral circuitry of the semiconductor device. Leakage of light through a clearance surrounding bonding pads 30 is eliminated by including an extended part 31, as part of a first layer 34 of bonding pads 30, which is disposed beneath the clearance and shields the substrate 23 from incident light. A light shield 32 covers a top surface of the semiconductor, with the exception of photodiode areas (not shown) and clearance areas for bonding pads 30, and has an extension 42 for shielding substrate 23 between bonding pads 30.

Referring to Fig. 9(a), first layer 34 and extended part 31 of bonding pads 30, and conductor 37, are formed by etching portions of the first aluminum wiring layer 1M. Referring to Fig. 9(b), second layer 35 of bonding pads 30, light shield 32, and extension 42, are formed by etching portions of the second aluminum wiring layer 2M. Thus, layers of the bonding pads 30, light shields 32 and extension 42, are configured into an overlapped structure occluding direct incident light paths to the surface of substrate 23.

Having described preferred embodiments of the invention with reference to the accompanying drawings, it is to be understood that the invention is not limited to those precise embodiments, and that various changes and modifications may be effected therein by one skilled in the art without departing from the scope or spirit of the invention as defined in the appended claims.

## Claims

1. A semiconductor device, incorporating a photodiode and peripheral circuits in a substrate, comprising;
a bonding pad disposed upon said substrate;
a light shield covering said peripheral circuits;
said bonding pad being electrically insulated from said light shield layer; and
said light shield and a first pad layer of said bonding pad overlapping such that direct paths of incident light upon said substrate are occluded.

2. A semiconductor device according to claim 1 comprising:
a first conductive layer;
said first pad layer being formed from said first conductive layer disposed upon said substrate;
said bonding pad having a second pad layer;
a second conductive layer; and
said second pad layer and said light shield being formed from a second conductive layer separated by an insulator from said first conductive layer except at said bonding pad.

3. A semiconductor device, incorporating a photodiode and peripheral circuits in a substrate, comprising:
first and second bonding pads disposed upon said substrate;
a first light shield covering said peripheral circuits and extending up to a clearance area around said first and second bonding pads;
a second light shield disposed between said first and second bonding pads;
said first and second bonding pads being electrically insulated from said first and second light shields;
said first and second bonding pads each having an extended pad layer; and
said first light shield, said second light shield, and said extended pad layers of said first and second bonding pads being overlapped such that direct paths of incident light upon said substrate are occluded.

4. A semiconductor device according to claim 3 comprising:
said first and second light shields being contiguous; and
said extended pad layers extending beyond said clearance area and overlapping said first and second light shields such that incident light is block from reaching said substrate.

5. A semiconductor device according to claim 4 comprising:
said first and second light shields having holes for outgassing of an isolating insulator therebelow; and
light shield plates disposed upon said substrate and beneath said holes and said isolating insulator such that incident light entering through said holes is occluded from reaching said substrate.

6. A semiconductor device according to claim 5 comprising:
said first and second light shields being formed from a top conductive layer;
said extended pad layers being formed from a middle conductive layer disposed beneath and said top conductive layer;
said middle conductive layer being insulated from said top conductive layer except at said first and second bonding pads;
said light shield plates being formed from a base conductive layer situated atop said substrate; and
said base conductive layer being insulated from said middle conductive layer except at said bonding pads.

7. A semiconductor device according to claim 3 comprising:
said second light shield over lapping said first light shield; and
said extended pad layers extending beyond said clearance area and overlapping said first and second light shields such that incident light is block from reaching said substrate.

8. A semiconductor device according to claim 7 comprising:
said first light shield being formed from a top conductive layer;
said extended pad layers being formed from a middle conductive layer disposed beneath and said top conductive layer;
said middle conductive layer being insulated from said top conductive layer except at said first and second bonding pads;
said second light shield being formed from a base conductive layer situated atop said substrate; and
said base conductive layer being insulated from said middle conductive layer except at said bonding pads.

9. A semiconductor device, having a photodiode and peripheral circuitry, comprising:
a substrate;
a plurality of bonding pads;
said plurality of bonding pads each including a plurality of pad layers superposed on each other;
said plurality of pad layers each including an extended pad layer and a base layer;
a first light shield being formed from an uppermost wiring layer deposited on a surface of said semiconductor device and shielding a portion of said substrate from incident light;
a second light shield deposited between adjacent bonding pads of said plurality of bonding pads for shielding another portion of said substrate from incident light;
said extended pad layer and said second light shield overlapping, thereby shielding still another portion of said substrate between a periphery of said base layer and a periphery of said second light shield; and
at least one insulation film disposed between said adjacent bonding pads, said extended pad layer, and said first and second light shields for electrically isolating said adjacent bonding pads from one another and from said first and second light shields.

10. A semiconductor device according to claim 9, wherein:
said plurality of bonding pads includes three layers superposed on each other;
said at least one insulation film includes a second layer insulation film superposed on a first layer insulation film;
said first layer insulation film isolates said extended pad layer from said second light shield; and
said second layer insulation film isolates said extended pad layer from said first light shield.

11. A semiconductor device according to claim 10, wherein said second light shield is disposed between said adjacent bonding pads on a level of said first light shield.

12. A semiconductor device according to claim 10, wherein said second light shield is disposed between said adjacent bonding pads on a surface of said substrate.

13. A semiconductor device according to claim 12, wherein at least one of said first layer and said second layer insulation film is made of polyamide.

14. A semiconductor device according to claim 9, wherein said plurality of bonding pads includes two layers superposed on each other.

15. A semiconductor device according to claim 14, wherein said second light shield is disposed between said adjacent bonding pads on a level of said first light shield.

16. A semiconductor device according to claim 14, wherein said second light shield is disposed between said adjacent bonding pads on a surface of said substrate.

17. A semiconductor device according to claim 16, wherein said at least one insulation film is made of polyamide.
